# EUROPEAN PATENT APPLICATION

(11) **EP 3 941 170 A1**
(43) Date of publication of application: **19.01.2022**
(21) Application number: 21185570.5
(22) Date of filing: 14.07.2021
(51) Int. Cl.: H05K 7/14, H05K 5/00

(54) **PROTECTIVE DEVICE AND PROTECTIVE METHOD FOR ELECTRONIC PRODUCTS AND ELECTRONIC DEVICE FOR AGRICULTURAL MACHINERY**

(30) Priority: 14.07.2020 CN 202021387099 U; 14.07.2020 CN 202010675183
(71) Applicant: FJ Dynamics Co., Ltd., Shenzhen, Guangdong 518000 (CN)
(72) Inventor: LI, ZI-XUAN, Shenzhen, 518000 (CN); XUE, WEI-LIAN, Shenzhen, 518000 (CN); WU, DI, Nanjing, 210000 (CN); YAO, YUAN, Nanjing, 210000 (CN)
(74) Representative: Zaboliene, Reda

(57) **Abstract**

A protective device and a protective method for insulating and buffering an electronic product against the vibration, humidity, heat, and chemicals found in outdoor agricultural machines and thus safeguarding and extending the service life of the electronic products includes a protection space in the device, the electronic products being protected by being suspended in the protection space of the protection device.

## Description

### TECHNICAL FIELD

The present disclosure relates to the field of protection of electronic products, in particular to a protection device and a protective method for an electronic product, and electronic device used for agricultural machinery.

### BACKGROUND

Tractors, harvesters, and planters, in mechanized form, have greatly improved the efficiency of agricultural production, and agricultural machinery is becoming more and more intelligent. Different from traditional agricultural machinery, intelligent agricultural machinery uses a large number of electronic products, such as printed circuit board assembly (PCBA), so that intelligent agricultural machinery has the ability to operate independently. Performance of intelligent agricultural machinery and reliability depends on the performance and reliability of the electronic products. The performance and reliability of the electronic products are closely related to the environment in which the electronic products are located, and the field environment and the conditions under which agricultural machines perform can be very harsh. According to experiments, the failure rate of electronic products used in the field environment is twice that in laboratory conditions. Compared with an ordinary outdoor environment, the agricultural field environment may have a higher humidity, and chemical substances are commonly used. The size of the electronic components (such as CPUs, resistors, capacitors, etc. mounted on the surface of printed circuit boards) of the electronic products is becoming smaller, and the gap between adjacent electronic components is correspondingly becoming smaller. A high density of electronic components renders electronic products more vulnerable to dust and heat in the agricultural environment.

Generally, an electronic product can be locked inside a mounting box, and the mounting box provides one or more plugs. One end of these plugs extends to the inside of the mounting box and is connected to the electronic product, the other end of these plugs extends to the outside of the installation box, so as to be connected with sensors, drivers, and other mechanisms on the agricultural machine. Such arrangements may have many drawbacks. First of all, when the smart agricultural machine is used in a very moist environment, with high heat of operation, the smaller sized water molecules in the air can penetrate the gap of the installation box and enter into the installation box, leading to corrosion in the installation box. The internal electronic product and the connection position of the corroded plug and the electronic product, especially when the application environment reaches a certain humidity, can facilitate electrochemical migration, and lead to leakage and signal distortion in a high-frequency circuit. Dust in the air of agricultural operations can easily adsorbs ionic pollutants which settle on the surface of the electronic product, and may cause failure of the connection position of the electronic product and the plug. Secondly, when smart agricultural machinery is used in salty conditions, the salt spray may cause damage to the coating of the metal structure of the electronic product; while the salt spray may also accelerate the rate of electrochemical corrosion and cause metal fracture and component failure. Third, when smart agricultural machinery is used in an application environment of high humidity, high temperature, and high salt spray, mold can enter and grow on the inside of the installation box and the following phenomena may occur: (1) the phagocytosis and reproduction of molds reduce the insulation of the organic materials of the electronic products, (2) the organic acid metabolized by molds will affect the insulation and electric strength of electronic products and may cause arcing. In addition, the operation of agricultural machinery generates strong vibrations which may be directly transmitted through the mounting box to the electronic products which are locked inside the mounting box. An electronic product subjected to vibration over a long period, especially a high frequency vibration, may eventually dislodge the electronic components mounted on the printed circuit board.

### SUMMARY OF THE INVENTION

The present disclosure provided a protective device and a protective method for an electronic product, and electronic device for agricultural machinery, wherein the protective device defines a protection space, and an electronic product can be suspended in the protection space of the protective device, so that the protective device insulates the electronic product against prevent vibration and reduces the harshness of the working environment, thereby helping to ensure the reliability and stability of the electronic product.

The present disclosure provides a protective device and a protective method for electronic products and electronic device for agricultural machinery, wherein the protective device provides a first box body, a second box body, and at least one vibration damper. A protection space is formed between the first box body and the second box body, wherein the electronic product is locked in the first box body, and the vibration damper is held between the electronic product and the second box body. In this way, the vibration damper allows the electronic product to be suspended in the protection space of the protection device.

The present disclosure provides a protective device and protective method for electronic products and electronic device for agricultural machinery, wherein the vibration damper absorbs the vibration of the first box body and/or the second box body. The method prevents vibration from being transmitted to the electronic product and improves the working environment of the electronic product.

The present disclosure provides a protective device and a protective method for electronic products and electronic device for agricultural machinery, wherein the protective device provides an annular box sealer, the box body sealer prevents a gap from being formed between the first box body and the second box body by being squeezed and deformed by the first box body and the second box body, thereby forming the closed protection space between the first box body and the second box body, so that moisture, salt or chemical leaks or spray, and mold can be prevented from entering the protective space between the first box and the second box.

The present provides a protective device and a protective method for electronic products and electronic device for agricultural machinery, wherein the vibration damper extends from the box body sealer to the electronic product, in this way, the vibration damper and the box body sealer cooperate with each other to allow the electronic product to be suspended in the protection space of the protection device.

The present disclosure provides a protective device and a protective method for electronic products and electronic device for agricultural machinery, wherein the protective device provides at least one connecting sealer, and the first box body defines at least one box body perforation. After a plug connector extends to the protection space through the box body perforation of the first box body, the connecting sealer is held between the plug connector and the first box body, and the connecting seal prevents a gap between the first box body and the plug connector by being squeezed and deformed by the first box body and the plug connector. A protection space is formed between the second box body and the second box body, so that contaminants are prevented from entering the protection space between the first box body and the second box body.

According to one aspect of the present disclosure, the present disclosure provides an electronic device for agricultural machinery, which includes:
An electronic product; and
A protective device, wherein the protective device defines a protection space, and the electronic product is suspended in the protection space of the protective device.

According to an embodiment of the present disclosure, the protection device includes a first box body, a second box body, and at least one vibration damper, wherein the first box body and the second box body are installed to form the protective space between the first box body and the second box body, wherein the electronic product is locked to the first box body in a manner that the vibration damper is held between the electronic product and the first box body, and the electronic product is suspended in the protection space of the protective device.

According to an embodiment of the present disclosure, the protective device includes four vibration dampers, each of the vibration dampers is held at a corner of the electronic product and the first box body.

According to an embodiment of the present disclosure, the protective device includes at least one circuit board bolt, the electronic product has at least one circuit board perforation, the vibration damper has a vibration damper perforation, and the circuit board bolt is screwed to the first box body after passing through the vibration damper perforation of one vibration damper, the circuit board perforation of the electronic product, and the vibration damper perforation of the other vibration damper.

According to an embodiment of the present disclosure, the protective device includes an annular box body sealer, the box body sealer is held between the first box body and the second box body, and the box body sealer fills any gap between the first box body and the second box body by being squeezed and deformed by the first box body and the second box body.

According to an embodiment of the present disclosure, the protective device includes a first box body, a second box body, at least one vibration damper and an annular box body sealer, wherein the first box body and the second box body are mutually mounted to form the protection space between the first box body and the second box body, wherein the box body sealer is held between the first box body and the second box body, the box body sealer fills any gap between the first box body and the second box body by being squeezed and deformed by the first box body and the second box body, wherein an outer side of the vibration damper extends outward to be connected to the box body sealer, an inner side of the vibration damper extends inward to be connected to the electronic product, and the electronic product is suspended in the protection space of the protective device.

According to an embodiment of the present disclosure, the outer side of the vibration damper is integrally connected to the box body sealer, and the inner side of the vibration damper is integrally formed on the electronic product.

According to an embodiment of the present disclosure, the electronic components of the electronic product are embedded in the material used for molding the vibration damper.

According to an embodiment of the present disclosure, the first box body and the second box body each defines a mounting groove, and a sum of depth dimension of the mounting groove of the first box body and depth dimension of the mounting groove of the second box body is smaller than thickness dimension of the box body sealer, wherein a part of the box body sealer is installed in the mounting groove of the first box body, a part of the box body sealer is installed in the mounting groove of the second box body, the part of the box body sealer that is not installed in the mounting groove of the first box body and the part of the mounting groove of the second box body are squeezed and deformed by the first box body and the second box body.

According to an embodiment of the present disclosure, the first box body has at least one box body perforation, and the box body perforation communicates with the protection space and external environment, wherein the electronic device further comprises at least one plug connector. The plug connector has an inner end and an exposed end corresponding to the inner end, the plug connector is perforated by the box body installed in the first box body, and the inner end of the plug connector is connected to the electronic product in the protection space of the protection device, and the exposed end of the plug connector is exposed to the external environment of the protection device.

According to an embodiment of the present disclosure, the protective device includes at least one connecting seal, the connecting seal is held between the plug connector and the first box body, and the connecting sealer fills any gap or space between the first box body and the plug connector by being squeezed and deformed by the first box body and the plug connector.

According to another aspect of the present disclosure, the present disclosure further provides a protective device for protecting an electronic product, wherein the protective device includes a first box body, a second box body, and at least one vibration damper, wherein the first box body and the second box body are installed to form a protection space between the first box body and the second box body, wherein the electronic product is locked to the first box body in a manner that the vibration damper is held between the electronic product and the first box body, and the electronic product is suspended in the protection space of the protective device.

According to an embodiment of the present disclosure, the first box body includes a bottom wall, a skirt wall, and at least one mounting boss, and the skirt wall extends upward from circumference of the bottom wall to form a cavity between the skirt wall and the bottom wall. The mounting boss extends upward from the bottom wall to allow the mounting boss to be held in the cavity in a manner so as to protrude from the bottom wall.

According to an embodiment of the present disclosure, the number of mounting bosses of the first box body is four, and these mounting bosses are spaced apart from each other.

According to an embodiment of the present disclosure, the protective device further includes an annular box body sealer, wherein the box body sealer is held between the skirt wall of the first box body and the second box body.

According to an embodiment of the present disclosure, the skirt wall of the first box body defines a mounting groove, and depth of the mounting groove of the skirt wall is smaller than thickness of the box body sealer.

According to an embodiment of the present disclosure, the first box body defines at least one box body perforation, and the box body perforation communicates with the protection space and the external environment.

According to another aspect of the present disclosure, the present disclosure further provides a method for protecting an electronic product used in field of agriculture, wherein the protective method includes the following steps:
(a) suspending an electronic product in a protection space of a protective device by at least one vibration damper of the protective device; and
(b) the vibration damper prevents vibration from being transmitted to the electronic product by absorbing vibration generated externally.

According to an embodiment of the present disclosure, in the step (a), the vibration damper is held between the electronic product and a first box body of the protective device, to allow the vibration damper to suspend the electronic product in the protection space of the protection device.

According to an embodiment of the present disclosure, the protective method further includes the step of: (c) squeezing the box body sealer held between the first box body and the second box body by the second box body and the first box body of the protective device, and deforming the box body sealer to infill any gap between the first box body and the second box body.

According to an embodiment of the present disclosure, the step (a) further includes the steps of:
(a.1) squeezing the box body sealer held between the first box body and the second box body by the first box body and the second box body of the protective device, and deforming the box body sealer; and
(a.2) allowing the outer side of the vibration damper surrounding the electronic product to be connected to the box body sealer and the inner side to be connected to the electronic product, to suspend the electronic product in the protection space of the protective device by the vibration damper.

According to an embodiment of the present disclosure, in the above method, the outer side of the vibration damper is integrally connected to the box body sealer, and the inner side of the vibration damper is integrally formed on the electronic product.

According to an embodiment of the present disclosure, in the above method, a part of the box body sealer is installed in the mounting groove of the first box body, a part of the box body sealer is installed in the mounting groove of the second box body, and the part of the box body sealer which is unconstrained and exposed is allowed to be squeezed and deformed by the first box body and the second box body.

### BRIEF DESCRIPTION OF THE DRAWINGS

FIG. 1 is a perspective view of an electronic device for installation in agricultural machinery according to an embodiment of the present disclosure.
FIG. 2A is an exploded schematic view of the electronic device according to the above-mentioned embodiment of the present disclosure from a perspective.
FIG. 2B is an exploded schematic diagram of the electronic device according to the above-mentioned embodiment of the present disclosure from another perspective.
FIG. 3 is a schematic perspective cross-sectional view of the electronic device according to the above-mentioned embodiment of the present disclosure.
FIG. 4 is an enlarged schematic diagram of position A in FIG. 3.
FIG. 5 is an enlarged schematic diagram of position B in FIG. 3.
FIG. 6A is an exploded schematic view of an electronic device for agricultural machinery according to another embodiment of the present disclosure.
FIG. 6B is an exploded schematic diagram of the electronic device according to the above-mentioned embodiment of FIG. 6A from another perspective.
FIG. 7 is a schematic perspective cross-sectional view of the electronic device according to the embodiment of FIG. 6A.
FIG. 8 is an enlarged schematic diagram of position C in FIG.7.

### DETAILED DESCRIPTION

The following description is used to disclose the present disclosure so that those skilled in the art can implement the present disclosure. The preferred embodiments in the following description are only examples, and those skilled in the art can think of other obvious variations. The basic principles of the present disclosure defined in the following description can be applied to other embodiments, modifications, improvements, equivalents, and other technical solutions that do not deviate from the spirit and scope of the present disclosure.

Those skilled in the art should understand that, in the disclosure of the present disclosure, the terms "longitudinal", "lateral", "upper", "lower", "front", "rear", "left", "right", the orientation or positional relationship indicated by "vertical", "horizontal", "top", "bottom", "inner", "outer", etc. are based on the orientation or positional relationship shown in the drawings, which is only for the convenience of describing the present disclosure and to simplify the description, rather than indicating or implying that the device or element referred to must have a specific orientation, be constructed and operated in a specific orientation, so the above terms should not be understood as limiting the present disclosure.

It can be understood that the term "a" should be understood as "at least one" or "one or more", that is, in one or more embodiments, the number of an element may be one or more, and the term "one" cannot be understood as a restriction on the number.

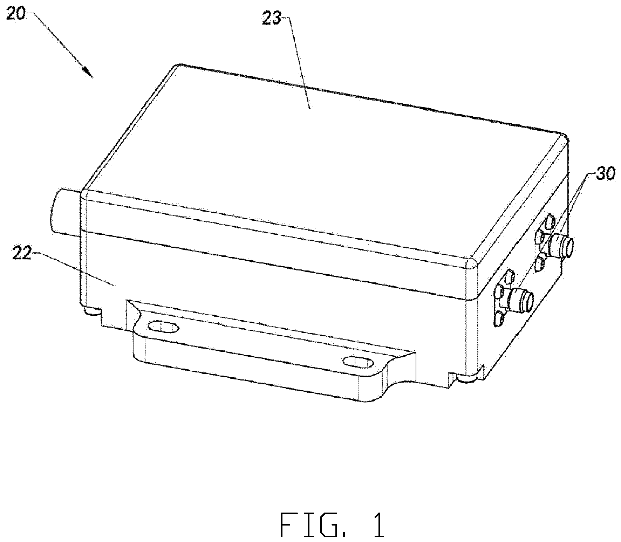

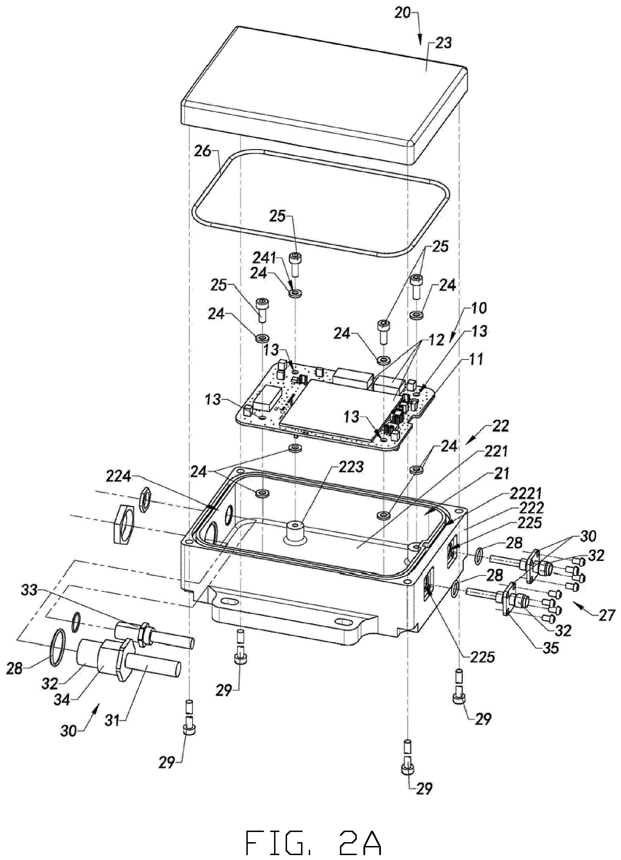

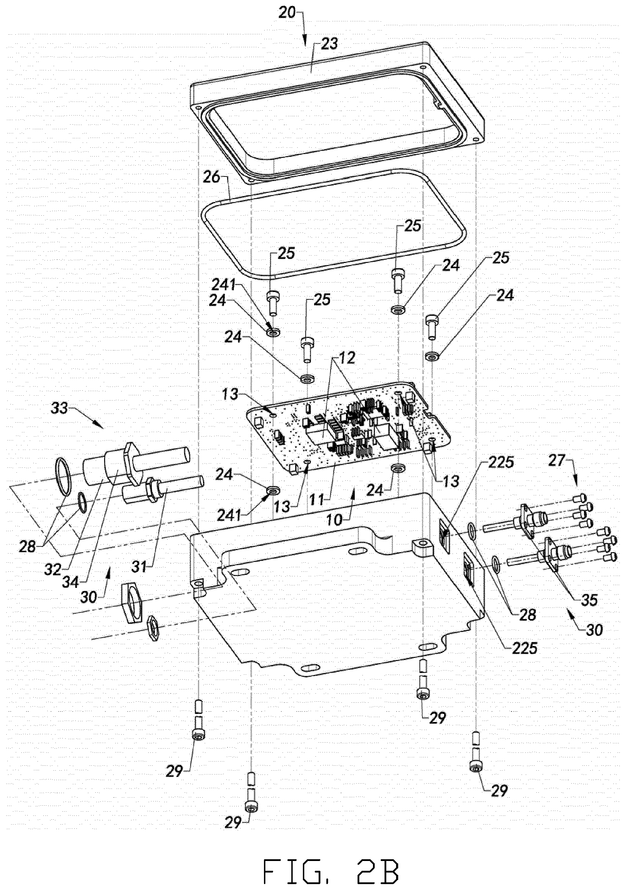

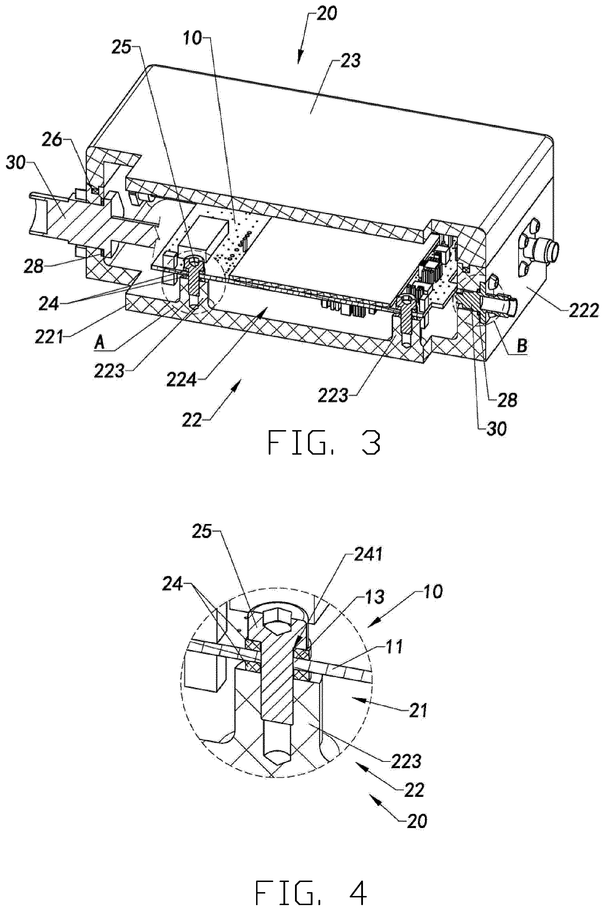

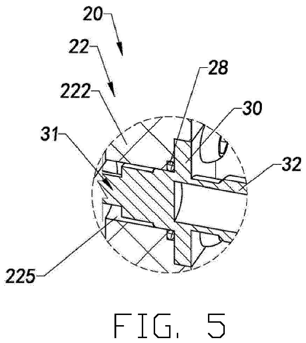

Referring to FIGS. 1 to 5 of the accompanying drawings of the specification of the present disclosure, an electronic device for agricultural machinery according to a preferred embodiment of the present disclosure is disclosed and illustrated in the following description, wherein the electronic device includes an electronic product 10 and a protective device 20. The protective device 20 has a protection space 21. The electronic product 10 is suspended in the protection space 21 of the protective device 20, so that the protective device 20 prevents vibration reaching the electronic product 10, to improve the working environment of the electronic product 10, thereby helping to ensure the reliability and stability of the electronic product 10.

It is worth mentioning that the type of the electronic product 10 is not limited in the electronic device of the present disclosure. For example, in the preferred example of the electronic device shown in FIGS. 1 to 5, the electronic product 10 includes a printed circuit board 11 and a series of electronic components 12, these electronic components 12 can be mounted on the printed circuit board 11 through a surface attachment process, wherein the electronic components 12 may be, but are not limited to, CPU, resistors, capacitors, etc.

According to FIGS. 1 to 5, the protective device 20 further includes a first box body 22, a second box body 23, and at least one vibration damper 24, wherein the first box body 22 and the second box body 23 can be mounted together to form the protection space 21 between the first box body 22 and the second box body 23. The electronic product 10 is locked to the first box body 22, and the vibration damper 24 is held between the electronic product 10 and the first box body 22, and thus passes through the vibration damper 24 allows the electronic product 10 to be suspended in the protection space 21 of the protective device 20. In this way, even when the protective device 20 is driven by agricultural machinery to generate large vibrations, the reliability of the electronic product 10 can also be ensured, the occurrence of the undesirable phenomenon that the electronic component 12 falls off the printed circuit board 11 can be avoided and the reliability of the electronic product 10 can be ensured.

Preferably, the vibration damper 24 has elasticity, so that the vibration of the protective device 20 can be transmitted to the protection space that is suspended in the protective device 20 by absorbing vibration. For example, in this preferred example of the electronic device of the present disclosure, the vibration damper 24 is made of an elastic material (such as rubber), so that the vibration damper 24 has elasticity, therefore, when the protective device 20 experiences vibration, the vibration damper 24 can absorb the vibration and prevent the vibration from being transmitted to the protection space 21 that is suspended in the protective device 20. Optionally, the vibration damper 24 is made of a hard material under tension (for example, forming a spring), so that the vibration damper 24 thereby has elasticity. The protective device 20 thus vibrates when driven by an agricultural machine, but the vibration damper 24 can absorb vibration and prevent the vibration from being transmitted to the protection space 21 within the protective device 20. The first box body 22 includes a bottom wall 221, a skirt wall 222, and at least one mounting boss 223, the skirt wall 222 integrally extends upward from the circumference of the bottom wall 221 to form a cavity 224 between the skirt wall 222 and the bottom wall 221, wherein the mounting boss 223 integrally extends upward from the bottom wall 221 to allow the mounting boss 223 to be held in the cavity 224 in such manner as to protrude from the bottom wall 221. The electronic product 10 is mounted on the mounting boss 223 of the first box body 22 through the vibration damper 24, and the vibration damper 24 is held between the electronic product 10 and the mounting boss 223 of the first box body 22, and the electronic product 10 is suspended in the cavity 224 of the first box body 22 by the mounting boss 223 of the first box body 22 and the vibration damper 24.

Specifically, the electronic product 10 has at least one circuit board perforation 13, and the vibration damper 24 has a damper perforation 241, wherein the circuit board perforation 13 of the electronic product 10 and the damper perforation 241 of the vibration damper 24 are aligned and the threaded hole of the mounting boss 223 of the first box body 22 will also be thereto aligned. The protective device 20 further includes at least one circuit board bolt 25, wherein the circuit board bolt 25 is screwed to the threaded hole of the mounting boss 223 of the first box body 22 after passing through the circuit board perforation 13 of the electronic product 10 and the damper perforation 241 of the vibration damper 24 in sequence. In this way, the electronic product 10 is locked to the first box body 22 by the circuit board bolt 25 to suspend the electronic product 10 in the cavity 224 of the first box body 22.

Preferably, the vibration damper 24 is held between the electronic product 10 and the circuit board bolt 25, so as to prevent the circuit board bolt 25 from directly contacting the electronic product 10. The circuit board bolt 25 is prevented from directly contacting the electronic product 10 when the circuit board bolt 25 is rotated, and vibration is not transmitted to the electronic product 10 via the circuit board bolt 25. In other words, the upper surface and the lower surface of the electronic product 10 corresponding to the position of each circuit board perforation 13 respectively hold the vibration dampers 24, after passing through the damper perforation 241 of one damper 24, the circuit board perforation 13 of the electronic product 10, and the damper perforation 241 of the other damper 24 in turn, the circuit board bolt 25 can be screwed to the threaded hole of the mounting boss 223 of the first box body 22. In this way, the two vibration dampers 24 can absorb vibration from the first box body 22 and the circuit board bolt 25 on the upper surface and the lower surface of the electronic product 10 respectively, so as to prevent the vibration from being transmitted to the electronic product 10.

In this specific example of the electronic device shown in FIG. 1 to FIG. 5, the first box body 22 includes four mounting bosses 223, and the mounting bosses 223 are held in the cavity 224 of the first box body 22 at intervals. The electronic product 10 has four circuit board perforations 13, and these circuit board perforations 13 are at four corners of the printed circuit board 11. Correspondingly, the protective device 20 includes four circuit board bolts 25. In this way, the four circuit board bolts 25 can lock the electronic product 10 to the first box 22 at each corner of the printed circuit board 11 of the electronic product 10.

The protective device 20 further includes an annular box body sealer 26, and the box body sealer 26 is held on the first box body 22 and the second box body 23, and the box body sealer 26 fills any gap between the first box body 22 and the second box body 23 by being squeezed and deformed by the first box body 22 and the second box body 23, thereby, a closed protective space 21 is formed between the first box body 22 and the second box body 23, in this way, moisture, salt spray, and mold can be prevented from entering the protection space 21 between the first box body 22 and the second box body 23, in order to avoid corrosion of the electronic product 10 held suspended in the protection space 21 of the protective device 20. Even when the agricultural machinery is used in a hot application environment with high humidity and salt or other chemicals, the performance and reliability of the electronic product 10 is ensured.

Further, the skirt wall 222 of the first box body 22 has a mounting groove 2221, and the depth dimension of the mounting groove 2221 is smaller than the thickness dimension of the box body sealer 26, wherein the box body sealer 26 is installed in the mounting groove 2221 of the skirt wall 222. When the first box body 22 and the second box body 23 are installed, the box body sealer 26 is prevented from being misaligned and to ensure that the box body sealer 26 is held between the first box body 22 and the second box 23. Optionally, the mounting groove 2221 is provided on the second box body 23. Optionally, the skirt wall 222 of the first box body 22 and the second box body 23 are each provided with one mounting groove 2221, and the depth of the two mounting grooves 2221 is less than and smaller than the thickness dimension of the box body sealer 26. When installing the first box body 22 and the second box body 23, the first box body 22 and the second box body 23 squeeze the box body sealer 26 and deform the box body sealer 26, and the box body sealer 26 fills a gap.

The first box body 22 of the protective device 20 has at least one box body perforation 225, and the box body perforation 225 is connected to the skirt wall 222 of the first box body 22 to connect the cavity 224 of the first box body 22 and the external environment. The electronic device further includes at least one plug connector 30, the plug connector 30 has an inner end 31 and an exposed end 32, wherein the inner end 31 of the plug connector 30 extends to the cavity 224 of the first box body 22 through the box body perforation 225 of the first box body 22, and can be connected to the electronic product 10. In this way, the exposed end 32 of the plug connector 30 is exposed outside of the protective device 20. Optionally, the exposed end 32 extends from the cavity 224 to the outside of the first box body 22 through the box body perforation 225, and the inner end 31 of the plug connector 30 is connected to the electronic product 10.

Further, the protective device 20 includes at least one plug bolt 27, and the plug bolt 27 is set to screw the plug connector 30 and the first box body 22, so the plug connector 30 and the first box body 22 can be reliably installed.

Furthermore, the protective device 20 includes at least one connecting seal 28, the connecting seal 28 is held between the plug connector 30 and the first box body 22, and the connecting seal 28 is squeezed and deformed by the first box body 22 and the plug connector 30. Thereby, a protection space 21 is formed between the first box body 22 and the second box body 23, so that moisture, salt spray and mold can be prevented from entering the protection space 21 between the first box body 22 and the second box body 23, in order to avoid corrosion of the electronic product 10 held suspended in the protection space 21 of the protective device 20. Therefore, even when the agricultural machinery is used in an application environment with high humidity and heat and high salt spray, the performance and reliability of the electronic product 10 can be ensured.

In this specific example of the electronic device shown in FIGS. 1 to 5, there are four plug connectors 30, they are a 4-pin aerial plug 33, a 12-pin aerial plug 34, and two SMA plugs 35. The 4-pin aerial plug 33 and the 12-pin aerial plug 34 are adjacently arranged at one end of the protective device 20, the two SMA plugs 35 are adjacently arranged at the other end of the protective device 20.

In addition, in this preferred example of the electronic device shown in FIGS. 1 to 5, the first box body 22 and the second box body 23 of the protective device 20 are made of aluminum alloy material, this allows the first box body 22 and the second box body 23 of the protective device 20 to withstand the collision and impact of foreign objects in the application environment of the agricultural machine, thereby ensuring the reliability of the electronic device. Preferably, the surfaces of the first box body 22 and the second box body 23 are treated with corrosion resistance material so that the first box body 22 and the second box body 23 have corrosion resistance characteristics. In this way, even when the agricultural machinery is used in an application environment with high humidity and heat and high salt spray, the performance and reliability of the electronic product 10 can be guaranteed.

Furthermore, the protective device 20 includes at least one box body bolt 29, and these box body bolts 29 are configured to hold the first box body 22 and the second box body 23 in place.

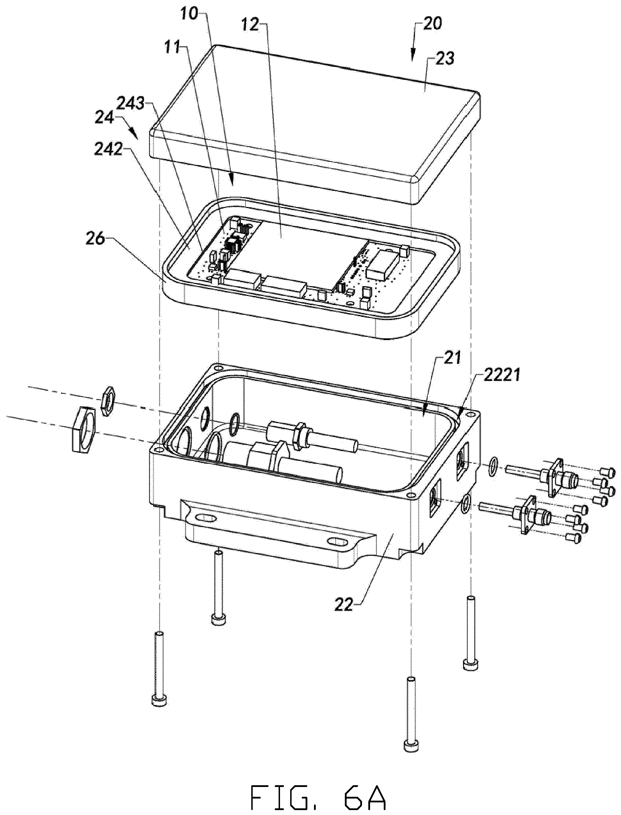

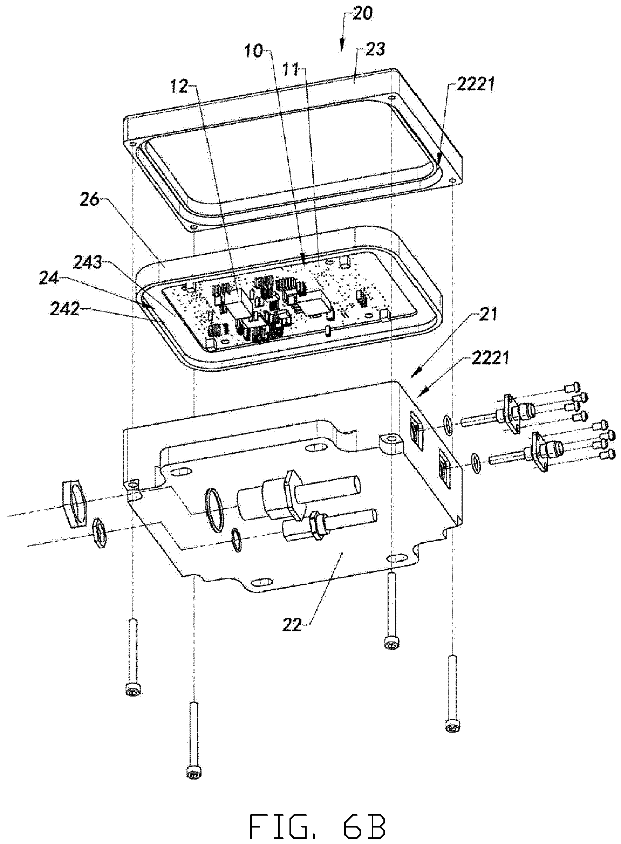

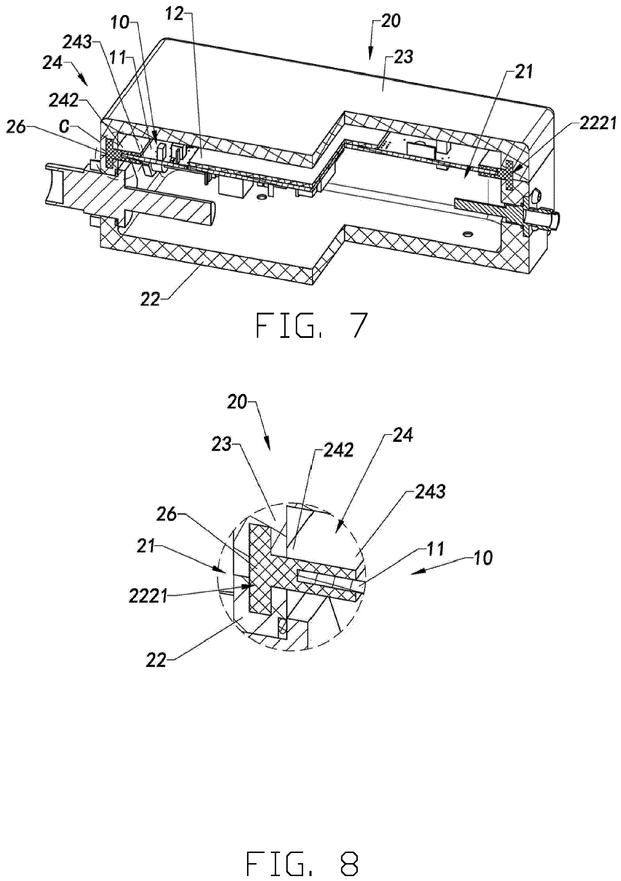

Referring to FIGS. 6 to 8 of the accompanying drawings of the specification of the present disclosure, an electronic device for agricultural machinery according to a preferred embodiment of the present disclosure is disclosed and illustrated in the following description, wherein the electronic device includes an electronic product 10 and a protective device 20. The protective device 20 has a protection space 21. The electronic product 10 is suspended in the protection space 21 of the protective device 20, so that the protective device 20 prevents vibration from being conducted to the electronic product 10, to improve the working environment of the electronic product 10, thereby helping to ensure the reliability and stability of the electronic product 10.

It is worth mentioning that the type of the electronic product 10 is not limited in the electronic device of the present disclosure. For example, in the preferred example of the electronic device shown in FIGS. 6 to 8, the electronic product 10 includes a printed circuit board 11 and a series of electronic components 12, these electronic components 12 can be mounted on the printed circuit board 11 through a surface attachment process, wherein the electronic components 12 may be, but are not limited to, CPU, resistors, capacitors.

Continue to refer to FIGS. 6 to 8, the protective device 20 further includes a first box 22, a second box 23, at least one vibration damper 24 and a box body sealer 26, wherein the first box body 22 and the second box body 23 can be mutually mounted to form the protection space 21 between the first box body 22 and the second box body 23, wherein the box body sealer 26 is held between the first box body 22 and the second box body 23, and the box body sealer 26 prevents a gap from being formed between the first box body 22 and the second box body 23 by being squeezed and deformed by the first box body 22 and the second box body 23, thereby forming the enclosed protective space 21 between the first box body 22 and the second box body 23, wherein the vibration damper 24 has an outer side 242 and an inner side 243 corresponding to the outer side 242, and the outer side 242 of the vibration damper 24 extends outward to be connected to the box body sealer 26, the inner side 243 of the vibration damper 24 extends inwardly to be connected to the electronic product 10, so that the electronic product 10 is suspended in the protective device 20 by the protection space 21 of the vibration damper 24.

Preferably, the outer side 242 of the vibration damper 24 is integrally connected to the box body sealer 26, and the inner side 243 of the vibration damper 24 is integrally formed on the printed circuit of the electronic product 10. The printed circuit board 11, and the vibration damper 24 surrounds the electronic product 10, so the vibration damper 24 can prevent the vibration of the protective device 20 from being transmitted to the electronic product 10 by absorbing vibration, thereby improving the working environment of the electronic product. For example, firstly, the printed circuit board 11 is placed in a molding die, and then a molding material (such as rubber material) is injected into the molding die to allow the molding material to wrap at least a part of the printed circuit board 11, and after the molding material is molded, a demolding operation is performed to allow the molding material to be integrally formed on the vibration damper 24 and integrally connected to the box body sealer 26. Preferably, the injection molding operation is performed after attaching the electronic components 12 to the printed circuit board 11, so that the molding material can embed the electronic components 12, to reliably connect the electronic components 12 and the printed circuit board 11.

Further, the first box body 22 and the second box body 23 each have a mounting groove 2221, wherein the sum of the depth dimension of the mounting groove 2221 of the first box body 22 and the depth dimension of the mounting groove 2221 of the second box body 23 is smaller than the thickness dimension of the box body sealer 26, wherein a part of the box body sealer 26 is installed in the mounting groove 2221 of the first box body 22, a part of the box body sealer 26 is installed in the mounting groove 2221 of the second box body 23, and The part of the box body sealer 26 that is not installed in the mounting groove 2221 of the first box body 22 and the mounting groove 2221 of the second box body 23 can be squeezed and deformed by the first box body 22 and the second box body 23, to prevent a gap from being formed between the first box body 22 and the second box body 23. By installing a part of the box body sealer 26 in the mounting groove 2221 of the first box body 22 and installing a part of the box body sealer 26 in the mounting groove 2221 of the second box body 23, it can avoid the displacement of the box body sealer 26 in the direction of the vibration damper 24 and reduce the deformation of the box body sealer 26 in the direction of the vibration damper 24, in this way, the vibration damping effect of the vibration damper 24 can be guaranteed.

According to another aspect of the present disclosure, the present disclosure provides a protective method for the electronic product 10, wherein the protective method includes the following steps:
(a) the electronic product 10 is suspended in the protection space 21 of the protective device 20 by at least one of the vibration dampers 24 of the protective device 20; and
(b) when the protective device 20 vibrates, the vibration damper 24 is allowed to prevent the vibration from being transmitted to the electronic product 10 by absorbing vibration.

In a preferred example of the protective method of the present disclosure, in the step (a), the vibration damper 24 is held between the electronic product 10 and the first box 22 of the protective device 20, allowing the vibration damper 24 to suspend the electronic product 10 in the protection space 21 of the protective device 20. Further, the protective method includes the steps of: (c) pressing the box body sealer 26 held between the first box body 22 and the second box body 23 by the second box body 23 and the first box body 22 of the protective device 20, to prevent the formation of a gap between the first box body 22 and the second box body 23.

In another preferred example of the protective method of the present disclosure, the step (a) further includes the steps:
(a.1) the box body sealer 26 held between the first box body 22 and the second box body 23 is pressed by the first box body 22 and the second box body 23 of the protective device 20, the box body sealer 26 is deformed to prevent the formation of a gap between the first box body 22 and the second box body 23;
(a.2) the outer side 242 of the vibration damper 24 surrounding the electronic product 10 is allowed to be connected to the box body sealer 26 and the inner side 242 of the vibration damper 24 to be connected to the electronic product 10, and the electronic product 10 is suspended in the protection space 21 of the protection device 20 by the vibration damper 24. Preferably, the outer side 242 of the vibration damper 24 is integrally connected to the box body sealer 26, and the inner side 242 of the vibration damper 24 is integrally formed on the electronic product 10. More preferably, in the above method, a part of the box body sealer 26 is allowed to be installed in the mounting groove 2221 of the first box body 22, the part of the box body sealer 26 is allowed to be installed in the mounting groove 2221 of the second box body 23, the part of the box body sealer 26 that is not installed in the mounting groove 2221 of the first box body 22 and the part of the mounting groove 2221 of the second box body 23 is allowed to be squeezed and deformed by the first box body 22 and the second box body 23.

Those skilled in the art can understand that the above embodiments are only examples, in which the features of different embodiments can be combined with each other to obtain implementations that are easily conceivable according to the disclosure of the present disclosure but are not clearly indicated in the drawings.

Those skilled in the art should understand that the above description and the embodiments of the present disclosure shown in the drawings are only examples and do not limit the present disclosure. The purpose of the present disclosure has been completely and effectively achieved. The functions and structural principles of the present disclosure have been shown and explained in the embodiments. Without departing from the principles, the implementation of the present disclosure may have any deformation or modification.

## Claims

1. An electronic device of agricultural machinery comprising:
an electronic product; and
a protective device, wherein the protective device defines a protection space, and the electronic product is suspended in the protection space of the protective device.

2. The electronic device according to claim 1,
wherein the protective device comprises a first box body, a second box body, and at least one vibration damper,
wherein the first box body and the second box body are mutually installed to form the protective space between the first box body and the second box body, and
wherein the electronic product is locked to the first box body in a manner that the vibration damper is held between the electronic product and the first box body, and the electronic product is suspended in the protection space of the protective device.

3. The electronic device according to claim 2, wherein the protective device comprises four of the vibration dampers, each of the vibration dampers is held between each corner of the electronic product and the first box body.

4. The electronic device according to claim 2, wherein the protective device comprises at least one circuit board bolt, the electronic product has at least one circuit board perforation, the vibration damper has a vibration damper perforation, and the circuit board bolt is screwed to the first box body after passing through the vibration damper perforation of one vibration damper, the circuit board perforation of the electronic product, and the vibration damper perforation of the other vibration damper.

5. The electronic device according to claim 4, wherein the protective device comprises an annular box body sealer, the box body sealer is held between the first box body and the second box body, and the box body sealer prevents a gap from being formed between the first box body and the second box body by being squeezed and deformed by the first box body and the second box body.

6. The electronic device according to claim 1, wherein the protective device comprises a first box body, a second box body, at least one vibration damper and an annular box body sealer, wherein the first box body and the second box body are mutually mounted to form the protection space between the first box body and the second box body, wherein the box body sealer is held between the first box body and the second box body, the box body sealer prevents a gap from being formed between the first box body and the second box body by being squeezed and deformed by the first box body and the second box body, wherein an outer side of the vibration damper extends outward to be connected to the box body sealer, an inner side of the vibration damper extends inward to be connected to the electronic product, and the electronic product is suspended in the protection space of the protective device.

7. The electronic device according to claim 6, wherein the outer side of the vibration damper is integrally connected to the box body sealer, and the inner side of the vibration damper is integrally formed on the electronic product.

8. The electronic device according to claim 7, wherein material used for molding the vibration damper embeds electronic components of the electronic product.

9. The electronic device according to claim 7, wherein the first box body and the second box body each defines a mounting groove, and a sum of a depth dimension of the mounting groove of the first box body and a depth dimension of the mounting groove of the second box body is smaller than a thickness dimension of the box body sealer, wherein a part of the box body sealer is installed in the mounting groove of the first box body, a part of the box body sealer is installed in the mounting groove of the second box body, the part of the box body sealer that is not installed in the mounting groove of the first box body and the part of the mounting groove of the second box body are squeezed and deformed by the first box body and the second box body.

10. The electronic device according to claim 9, wherein the first box body defines at least one box body perforation, and the box body perforation communicates with the protection space and external environment, wherein the electronic device further comprises at least one plug connector, the plug connector has an inner end and an exposed end corresponding to the inner end, the plug connector is perforated by the box body installed in the first box body, and the inner end of the plug connector is connected to the electronic product in the protection space of the protection device, and the exposed end of the plug connector is exposed to the external environment of the protection device.

11. The electronic device according to claim 10, wherein the protective device comprises at least one connecting seal, the connecting seal is held between the plug connector and the first box body, and the connecting sealer prevents a gap from being formed between the first box body and the plug connector by being squeezed and deformed by the first box body and the plug connector.

12. A protective device for protecting an electronic product, comprising a first box body, a second box body, and at least one vibration damper, wherein the first box body and the second box body are mutually installed to form a protection space between the first box body and the second box body, wherein the electronic product is locked to the first box body in a manner that the vibration damper is held between the electronic product and the first box body, and the electronic product is suspended in the protection space of the protective device.

13. The protective device according to claim 12, wherein the first box body comprises a bottom wall, a skirt wall, and at least one mounting boss, and the skirt wall integrally extends upward from circumference of the bottom wall to form a cavity between the skirt wall and the bottom wall, the mounting boss integrally extends upward from the bottom wall to allow the mounting boss to be held in the cavity in a manner protruding from the bottom wall.

14. The protective device according to claim 13, wherein a number of the mounting bosses of the first box body is four, and the mounting bosses are spaced apart from each other.

15. The protective device according to claim 13, further comprising an annular box body sealer, wherein the box body sealer is held between the skirt wall of the first box body and the second box body, and the box body sealer prevents a gap from being formed between the first box body and the second box body by being squeezed and deformed by the skirt wall of the first box body and the second box body.

16. The protective device according to claim 15, wherein the skirt wall of the first box body defines a mounting groove, and a depth dimension of the mounting groove of the skirt wall is smaller than thickness dimension of the box body sealer.

17. The protective device according to claim 16, wherein the first box body defines at least one box body perforation, and the box body perforation communicates with the protection space and the external environment.

18. A protective method applicable in electronic products, the protective method comprising:
(a) suspending an electronic product in a protection space of a protective device by at least one vibration damper of the protective device; and
(b) preventing vibration from being transmitted to the electronic product by the vibration damper absorbing vibration when the protective device vibrates.

19. The protective method according to claim 18, wherein in (a), the vibration damper is held between the electronic product and a first box body of the protective device, to allow the vibration damper to suspend the electronic product in the protection space of the protection device.

20. The protective method according to claim 19, further comprising: (c) squeezing the box body sealer held between the first box body and the second box body by the second box body and the first box body of the protective device, and deforming the box body sealer to prevent formation of a gap between the first box body and the second box body.

21. The protective method according to claim 18, wherein (a) further comprises:
(a.1) squeezing the box body sealer held between the first box body and the second box body by the first box body and the second box body of the protective device, and deforming the box body sealer to prevent formation of a gap between the first box body and the second box body; and
(a.2) allowing the outer side of the vibration damper surrounding the electronic product to be connected to the box body sealer and the inner side to be connected to the electronic product, to suspend the electronic product in the protection space of the protective device by the vibration damper.

22. The protective method according to claim 21, wherein the outer side of the vibration damper is integrally connected to the box body sealer, and the inner side of the vibration damper is integrally formed on the electronic product.

23. The protective method according to claim 22, wherein a part of the box body sealer is installable in the mounting groove of the first box body, a part of the box body sealer is allowed to be installed in the mounting groove of the second box body, the part of the box body sealer that is not installed in the mounting groove of the first box body and the part of the mounting groove of the second box body is allowed to be squeezed and deformed by the first box body and the second box body.
